# EUROPEAN PATENT APPLICATION

(11) **EP 1 385 208 A2**
(43) Date of publication of application: **28.01.2004**
(21) Application number: 03102100.9
(22) Date of filing: 10.07.2003
(51) Int. Cl.: H01L 23/498

(54) **FOLDED TAPE AREA ARRAY PACKAGE WITH ONE METAL LAYER**

(30) Priority: 22.07.2002 US 200276
(71) Applicant: Texas Instruments Incorporated, Dallas, Texas 75251 (US)
(72) Inventor: Hortaleza, Edgardo R., Garland, TX 75044 (US)
(74) Representative: Holt, Michael

(57) **Abstract**

An inexpensively fabricated area array semiconductor device substrate having patterned metal interconnections on one surface of a flexible tape 501 is slit in non-patterned regions of each quadrant, and folded so that chip contact pads 507 are located on the top of the substrate, the leads wrap around the edges, and external solder ball contact pads are on the opposite surface of the substrate, thereby eliminating the need for conductive vias. A chip 503 is connected to the substrate either by conventional wire bonding 510, or by flip chip interconnection. In different embodiments, heat spreaders or other rigid core materials are incorporated, as well as various configurations of stress absorbing layers which assure reliable device assembly.

## Description

### FIELD OF THE INVENTION

This invention relates generally to semiconductor devices, and more specifically to packaging of semiconductor devices.

### BACKGROUND OF THE INVENTION

The need within the semiconductor industry for reduced size and increased complexity of electronic components has resulted in smaller and more complex integrated circuits. The same trends have forced the development of IC packages having smaller footprints, and better performance. Area array packages, such as ball grid array (BGA) and chip scale packages (CSP) have been developed primarily to meet the need for smaller footprints. BGAs and/or CSPs are usually square or rectangular packages with contact terminals in the form of an array of solder balls, protruding from the bottom of the package. These terminals are designed to be connected to a plurality of pads located on the surface of a printed wiring board, or other next level interconnection circuit.

Contacts to chip input /output pads are typically either by wire bonding, or by flip chip interconnection to metallized leads and pads on the top side of a package substrate or interposer. In turn, these pads are connected through the package substrate to the solder ball terminals on the opposite side of an area array package. Leads may be formed directly on the package substrate using technology from the printed wiring board industry, or more complex and tightly spaced leads may be formed on an insulating flexible tape interposer. Use of flexible tape with patterned metal leads has evolved from TAB (tape automated bond) interconnected devices wherein gold bumps on the input/output pads of a semiconductor device were bonded to pads on the tape.

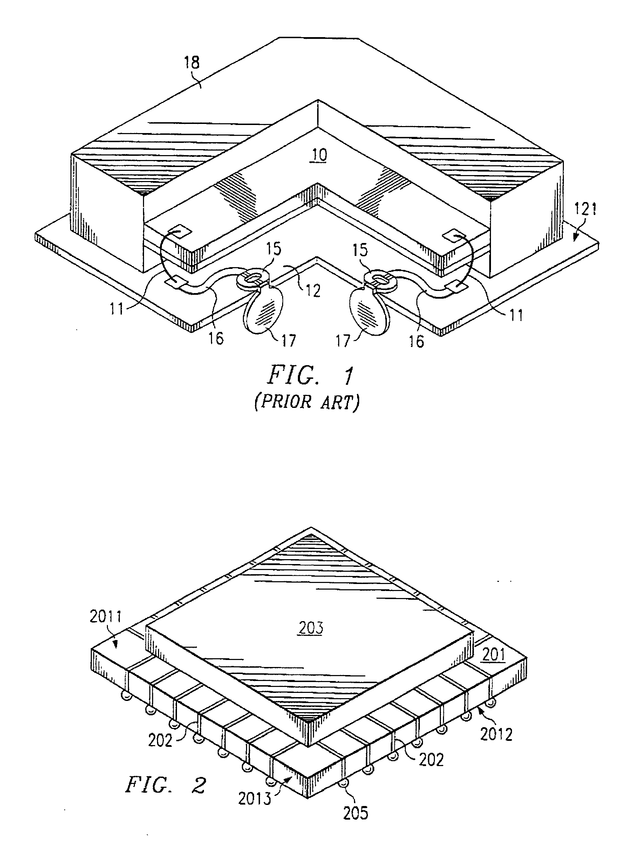

Metal patterning on tape typically involves photolithographic processing wherein a relatively thin layer of metal is deposited or laminated to the tape, a photoresist applied and exposed, and the unwanted metal removed by an etching process. The tape is then attached to the package substrate, or in the case of some designs, such as The Texas Instruments Micro Star ™ package, illustrated in Figure 1, the tape forms the bottom of the package. This device includes a semiconductor chip 10 connected by wire bonds 11 to patterned metal pads on a flexible tape substrate 12, and the assembly is overmolded with a plastic encapsulant 18. Solder balls 17 are connected through conductive vias 15 in the substrate 12 to metallized traces 16 on the upper surface 121 of the substrate where the chip is attached.

There are a number of advantages to flex tape interconnections; 1) the materials and technology for fabrication of high performance copper based leads on thermally stable flexible tapes have been developed for a number of years, 2) processes for patterning high density leads on high dielectric strength tapes are known, 3) thin tape substrates impart very little stress on chip interconnections, and 4) the tapes may be readily cut and formed in a variety of shapes.

However, there are disadvantages to area array packages having flex tape conductors, including in particular, the difficulty of fabrication reliable conductive vias, and the difficulty in testing such vias to insure reliable contact. Further, if interconnected metal patterning is needed on both sides of the tape, difficult and costly processes are involved.

A reliable, low cost tape substrate package would be welcome in the industry, in particular for those devices which are cost sensitive, and where the high cost of known tape substrates may preclude their fabrication as area array devices.

### SUMMARY OF THE INVENTION

It is an object of the invention to provide an area array semiconductor device package having a flex tape substrate wherein metal leads are patterned only on one surface of the tape.

It is an object of the invention that the substrate is amenable to either wire bond or flip chip interconnections with the chip.

It is an object of the invention to eliminate the need for conductive vias through the substrate.

It is an object of the invention that specific embodiments be applicable to high power devices which require a heat spreader core, and others to low power devices having no core.

It is an object of the invention to provide a reliable package wherein stress due to thermal expansion mismatches is minimized on sensitive components of the assembly.

It is an object of the invention that the package interconnections be accurately and easily tested.

It is an object of the invention that the package is inexpensive to fabricate, and to assemble.

It is further an objective of the invention that fabrication of the substrate is amenable to highly automated processing, such as using reel to reel transport.

The above and other objectives are met by a series of versatile and inexpensive semiconductor packages wherein metal interconnections are patterned on a single surface of a flexible tape, the tape is slit in non-patterned regions of each quadrant, and each quadrant is folded so that chip contact pads are located on the top of the substrate, the leads wrap around the edges, and external solder ball contact pads are on the opposite surface of the substrate, thereby eliminating the need for conductive vias.

The chip is connected to the substrate, either by conventional wire bonding, or by flip chip interconnection. In some embodiments, dictated by the power requirements of the semiconductor device, the tape is folded around a heat spreader. In some embodiments, a stress relieving compound is incorporated within the substrate, and is positioned to minimize stress on selected sensitive portions of the assembly.

The foregoing and other objects, features, and advantages of the invention will become more apparent from the following detailed description of preferred embodiments, with reference to the accompanying drawings.

### BRIEF DESCRIPTION OF THE DRAWINGS

Figure 1 is an area array package having a tape substrate (Prior art);
Figure 2 illustrates a semiconductor device of the current invention on a folded tape substrate having a single layer of patterned metal;
Figure 3a is a tape having a metal pattern of leads and pads prior to folding;
Figure 3b shows the patterned tape partially folded so that chip interconnection pads are on the top surface;
Figure 4a is an inventive tape device partially folded for flip chip assembly wherein solder ball pads are on the folded sections;
Figure 4b illustrates a flip chip bumped semiconductor device and a tape substrate with contacts which mirror the bump on the central, unfolded surface of the substrate;
Figure 5 is a folded tape area array package having wire bond interconnections to the chip;
Figure 6a demonstrates a folded tape package which includes a rigid core or heat spreader;
Figure 6b illustrates leads on the top side of a folded tape package having a rigid core;
Figure 6c is the under side of a package with BGA pads;
Figure 7 is a flip chip embodiment of a folded tape device having a rigid core, a stress absorbing layer, and further including an underfill material;
Figure 8 is a flip chip folded tape device having a rigid core with stress absorbing layers covering both major surfaces of the core;
Figure 9 is a wire bonded folded tape device having a rigid core with a stress absorbing layer protecting the solder bumps; and
Figure 10 is a cross section of a flip chip folded tape device having a stress absorbing layer between the inner surfaces of the tape.

### DETAILED DESCRIPTION OF THE DRAWINGS

Figure 2 illustrates an area array folded flex tape device with leads interconnecting a semiconductor chip to solder ball contacts. The folded tape substrate 201 includes an array of metal leads 202 on the insulating tape extending from beneath the semiconductor chip 203 on the first surface 2011 of the substrate, around the edges 2013, and terminating on the underside at an array of solder balls 205 protruding from the second surface 2012 of the substrate. This device structure is unique in that continuous metal leads wrap around the substrate to connect the solder balls to the chip contacts. This configuration eliminates the need for conductive vias formed through the substrate, and thereby avoids a major failure mechanism in area array packages. Vias of existing devices filled either by plating, by solder wicking, or other means, are subject to voids and other imperfections which may result in open or intermittent circuits, and further are difficult to test accurately.

The substrate is formed by depositing, laminating or otherwise adhering a layer of metal on one surface of a flexible (flex) insulating tape, and patterning the array of leads and contact pads. The opposite surface of the tape is inert, having no electrically conductors. The second or inert surface may be covered by film of adhesive which will adhere to itself, or to another component incorporated within the substrate. Fabrication of the flex tape substrate preferably is in strip format, and is amenable to highly automated manufacturing techniques, such as reel to reel transporting the tape through various processes prior to separating into individual substrates.

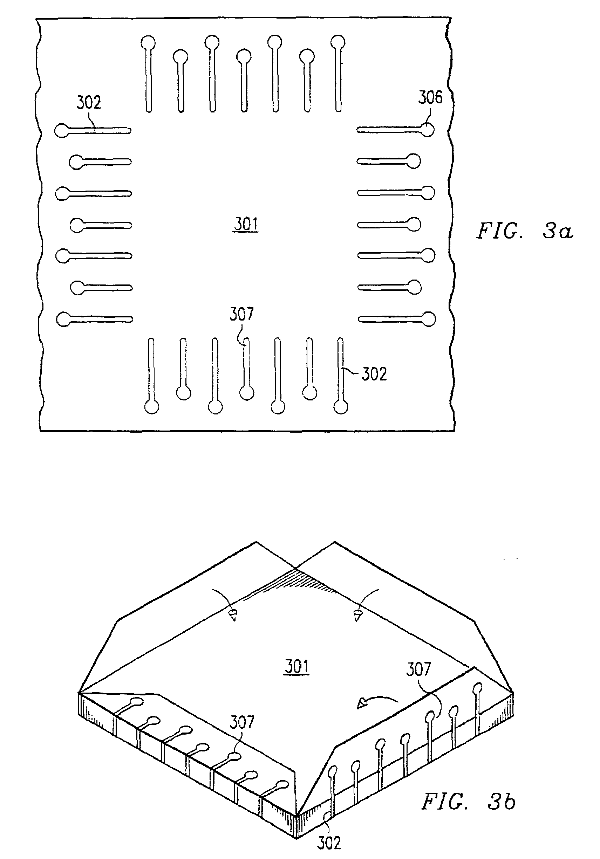

Figure 3a illustrates the first surface of the tape 301 having an array of patterned leads 302 with contact pads 306, 307 on both ends. Preferably the tape is a thermally stable polymeric material from the polyimide family having good dielectric characteristics. Leads 302 and pads 306,307 are arrayed in each quadrant forming a square or rectangular pattern with a plurality of leads in each section.

Preferably the outer pads 306 are larger than those on the opposite end, and provide the site for solder ball attachment. The smaller inner pads 307 provide contact locations for chip interconnection, either as wire bond lands, or bump pads. By way of reference, solder balls denote contacts to a printed wiring board or other next level interconnection, while bumps refer to chip contacts to a substrate or interposer. The chip contact bumps may be of solder, conductive adhesive, or other material known in the industry. Generally, the solder balls are larger in diameter than the bump connections.

The outer pads 306 preferably are staggered to allow placement of larger solder balls, and the inner pads 307 may be staggered to mirror flip chip bump contacts, or may be in a single row, as illustrated in Figure 3a for perimeter flip chip contact, and/or for wire bond pads.

In Figure 3b, the tape 301 is partially folded and formed into a package substrate. The tape has been inverted so that the metal pattern is face down, the corners have been slit, and each side is being folded inwardly so that the smaller pads 307 for wire bond or flip chip contact are positioned on the top surface of the device. Leads 302 extend around the formed substrate edge, and connect to solder ball pads on the bottom side of the substrate.

Both the flexible tape and patterned metal are sufficiently malleable to allow folding so that chip pads and solder ball pads are on opposite surfaces. A preferred tape is a thermally stable polymer from the polyimide family, well known in the semiconductor industry for its low dielectric constant, and as the preferred material for various tape interconnection and packaging applications. Flex tape is preferably in the range of 0.001 to 0.003 inches thick.

The preferred metal conductors includes a copper alloy with a thin film of nickel or other barrier metal, covered by a thin film of gold or other noble, solderable metal on the exposed surface.

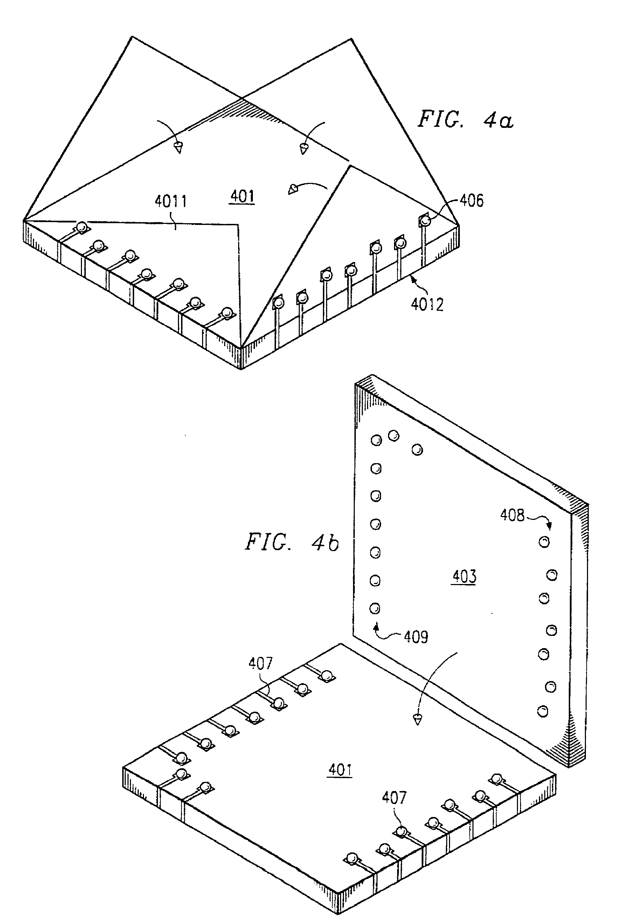

The inventive flex tape substrate is adaptable to flip chip interconnection, as well as to wire bonded devices. Figures 4a and 4b illustrate steps in the fabrication of a flip chip embodiment. The tape has been patterned and slit, and the substrate is partially formed by folding the corners of the unpatterned surfaces inwardly. The unpatterned surfaces of the folded tape are adhered together, or to a core member in order to provide a mechanically stable substrate.

In the embodiment illustrated in Figure 4a, larger terminals 406 for solder balls are positioned on the folded sections 4011 of the substrate 401, and the chip contact terminals are on the underside or unfolded 4012 surface. In Figure 4b the tape substrate 401 is inverted from the view in Figure 4a. A flip chip semiconductor device 403 having a plurality of contact bumps, arrayed over the active circuit 408, or perimeter arrayed 409, is aligned with the respective receiving pads 407 on the substrate and attached. A specific substrate design may accommodate either area array 408 or perimeter 409 bump interconnection to the chip.

In yet another embodiment, the tape is folded to expose the flip chip terminals on the folded sections of the substrate, and the larger solder bump terminals on the center surface, similar to the arrangement in figure 3b.

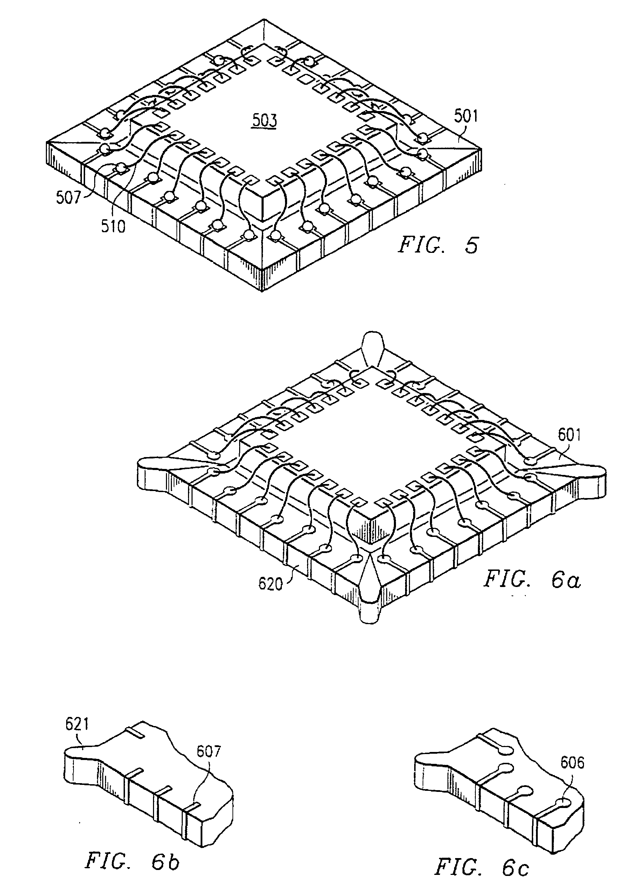

Figure 5 shows the inventive single layer metal folded flex tape substrate 501 having a semiconductor device 503 connected by wire bonds 510. It can be seen that fine wires bonded to the chip pads are connected to bonding lands or pads 507 on the substrate. The assemblage will subsequently be encapsulated to protect the chip and bond wires, and solder balls will be attached to the pads on the underside.

Figure 6a illustrates another embodiment of the flex tape 601 having a metal leads patterned on a single side formed around a rigid core 620 which preferably has high thermal conductivity, and thereby serves as a heat spreader. The core or heat spreader 620 of approximately the package external dimensions may include a thermally activated adhesive coating to secure the tape 601. The tape is formed around the core, heat and pressure applied to secure the tape and provide a stable, rigid substrate. The heat spreader core is preferably an alloy or clad metal, such as copper/invar/copper, or a thermally conductive ceramic having relatively low coefficient of thermal expansion (CTE). Either the low expansion clad metal or ceramic provide CTE match to the silicon chip, and are particularly well suited to flip chip applications wherein thermal stresses on small flip chip interconnection joints are of concern. Thickness of the heat spreader core is determined by geometric requirements of the finished semiconductor device. Because many devices have requirements for thickness, as well as overall package dimensions, thickness is preferably in the range of 0.005 to 0.020 inches.

As shown in Figure 6b, the core may include protrusions 621 in each corner which help in the protection of the exposed leads on the package sides from mechanical damage. Bonding lands, or pads 607 on the top side of the package provide sites for chip connections, and in Figure 6c, BGA pads 606 for solder balls on the bottom side of the package are staggered.

Semiconductor devices having solder bump and/or ball joints connecting either the chip to the package substrate or the substrate to the next level interconnection are subject to fatigue resulting from CTE mismatches. Thin flex tape substrates exert very little stress on the joints; however, a rigid silicon chip having an expansion coefficient of about 2.3 PPM is poorly matched to a typical printed board having expansion ranging from 20 to 50 PPM. To mitigate such stresses arising from thermal mismatch, in the current invention, a stress absorbing material is incorporated between the folded surfaces of the tape substrate. Different embodiments of the inventive substrate allow the stress absorbing material to be positioned on either or both sides of a stiff core or heat spreader, or between the folded tapes having no rigid core.

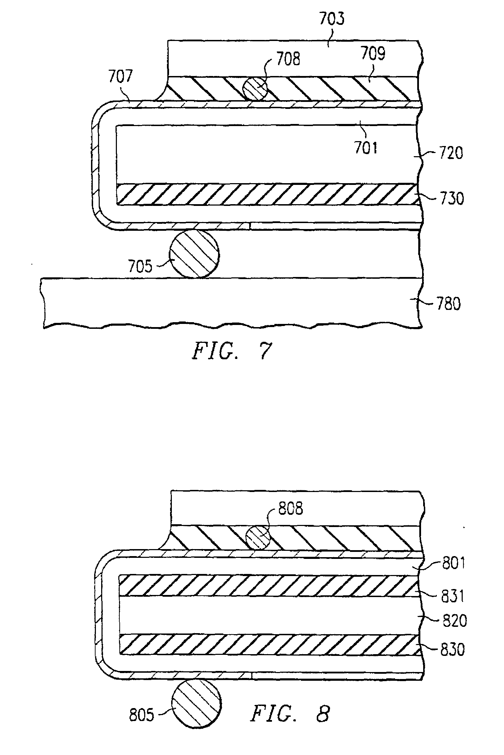

Figure 7 is a cross section of a flip chip device having a chip 703 with solder bumps 708 and solder balls 705 attached to the patterned metal 707 on a flex tape 701 substrate. A rigid core 720 having a coefficient of thermal expansion similar to that of the chip 703 is in contact with the tape 701 on the top or chip side of the device. A stress absorbing material 730 is incorporated between the core 720 and tape 701 on the bottom or solder ball 705 side of the package in order to mitigate stresses on the solder joint which arise from CTE mismatch between the core and circuit board 780. The low modulus stress absorbing material preferably is thermally conductive, may be electrically conductive or insulating, may be an adhesive, or may be attached by an adhesive, and the thickness of the layer is largely a function of its elastic modulus.

In a specific embodiment, an underfill material 709 is added between the chip 703 and tape 701 substrate to further protect the chip interconnection joints.

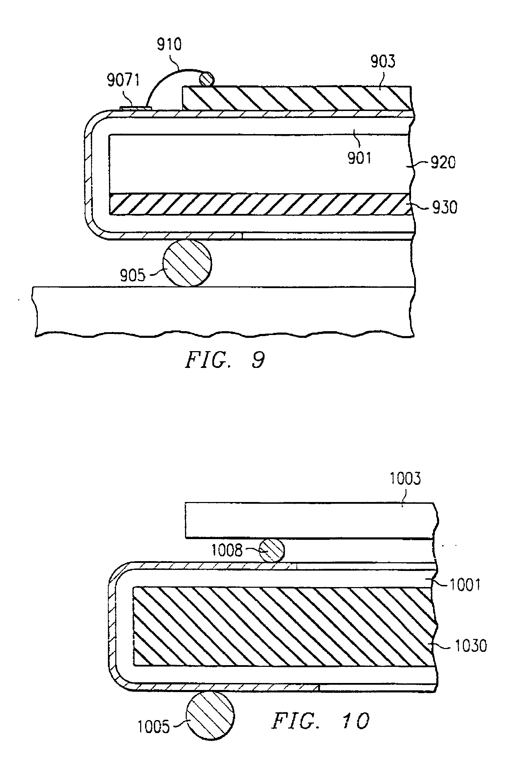

In yet another embodiment, as shown in Figure 8, a layer of stress absorbing material 831 is incorporated within the folded substrate between the 801 tape and the rigid core 820 on the chip side. The layer 831 absorbs much of the stress on the bump 808 interconnection arising from thermal mismatch, while a similar layer 830 on the bottom side of the core protects the solder ball 805 joints.

Figure 9 illustrates an embodiment wherein a chip 903 has wire bond 910 contacts to a tape 901 substrate having a rigid core 920. A layer of low modulus material 930 between the core and tape on the solder ball side relieves stress on the solder joints. The chip 903 is CTE matched to the core 920, and the rigid core provides stable bonding land sites 9071 for reliable wire bonds.

Figure 10 is a cross section of a flip chip embodiment of the invention having no core material, and having a stress absorbing layer 1030 captured within the inert, folded surfaces of the tape 1001. The chip 1003 is the most rigid member of this device, and the stress absorbing layer 1030 protects both the solder ball 1005 and bump 1008 joints.

A significant advantage of the continuous metal leads from chip to solder ball is that continuity of the interconnection is readily tested. Resistance of each lead is tested between pads 306 and 307, as shown in Figure 3 prior to folding the substrate. Those test results may be compared to values of the leads for the folded substrate, as shown in figures 3b and 4 to insure that there has been no performance deterioration. Elimination of vias with voids and other defects which plague existing area array substrates allows the finished devices to be reliably and inexpensively tested and analyzed.

The previous embodiments have described a square or rectangular device having quadrants. It should be obvious that the folded tape concept is applicable to center bonded devices, or other devices having two or more sides.

It can be seen that there are many applications of a low cost flex tape package wherein metal leads are patterned on a single surface of the tape, and the tape is folded to allow the leads to make contact with both the chip and external contact points. The previously described embodiments are intended to provide examples, but many other modifications and variations will become apparent to those skilled in the art. It is therefore intended that the appended claims be interpreted as broadly as possible in view of the prior art.

## Claims

1. An area array semiconductor device including;
a flexible tape substrate having continuous metal leads with chip and solder ball contact pads on either end, patterned on the first surface of the tape,
said tape slit at the corners and folded to expose the chip contact pads on the top of the formed substrate, and the solder ball contacts on the bottom of the substrate, and
a semiconductor chip connected to said chip contact pads.

2. A semiconductor device as in claim 1 wherein said chip is connected by wire bonds.

3. A semiconductor device as in claim 1 wherein said chip is connected by flip chip bumps.

4. A semiconductor device as in any one of claims 1 to 3 further including a stress absorbing layer incorporated within the formed substrate.

5. A semiconductor device as in any one of claims 1 to 4 further including a rigid core located within the formed substrate in contact with the second surface of said tape.

6. A device as in claim 5 wherein said rigid core is thermally conductive.

7. A device as in claim 5 or 6 which further includes one or more stress absorbing layers juxtapositioned on either or both sides of said rigid core.

8. A method for forming an area array folded flexible tape substrate, including the following steps;
a) depositing a layer of metal on one surface of a thin, flexible dielectric film,
b) depositing, exposing, and developing a photoresist to pattern an array of leads and contact pads,
c) etching to remove unwanted metal to form an array of metal leads,
d) slitting the film at each corner of an individual patterned substrate, and
e) folding the film at each quadrant to provide a substrate having chip contacts on one surface, and solder ball contacts on the opposite surface.

9. A method as in claim 8 which further includes the step of placing a rigid core on the unpatterned film surface prior to folding the film.

10. A method as in claim 9 which further includes the step of placing one or more layers of stress absorbing material on either or both major surfaces of said core prior to folding the film.
